# EUROPEAN PATENT APPLICATION

(11) **EP 4 804 219 A1**
(43) Date of publication of application: **09.09.2026**
(21) Application number: 25200952.7
(22) Date of filing: 09.09.2025
(51) Int. Cl.: H01F 17/00, H01F 21/12

(54) **STRUCTURE AND METHOD OF SWITCHABLE GROUND SHIELD FOR INDUCTORS**

(30) Priority: 06.03.2025 US 202519072442
(71) Applicant: GlobalFoundries U.S. Inc., Malta, NY 12020 (US)
(72) Inventor: Vanukuru, Venkata Narayana Rao, 560045 Bangalore (IN); Baipadi, Varuna A., 560045 Bangalore (IN); Kunnathodi, Muhammed Shafi, 560045 Bangalore (IN)
(74) Representative: Grünecker Patent- und Rechtsanwälte PartG mbB

(57) **Abstract**

An integrated circuit (IC) structure. The structure includes: a substrate; an inductor positioned adjacent the substrate; and an electrically switchable ground shield positioned between the inductor and the substrate, wherein the electrically switchable ground shield is controlled by a transistor.

## Description

### BACKGROUND

The present disclosure relates generally to structures that provide on-chip inductance, and more particularly to semiconductor structures having a switchable ground shield to provide changeable self-resonance frequency.

An "on-chip inductor" refers to an inductor that is directly integrated onto a semiconductor chip, often constructed as a planar spiral pattern of metal on the chip's surface. On-chip inductors store magnetic energy that can optimize operating characteristics of integrated circuits (ICs). On-chip inductors are particularly useful in high-frequency applications, such as ICs having radio frequency (RF) circuits.

### SUMMARY

All aspects, examples and features mentioned below can be combined in any technically possible way.

An aspect of the disclosure provides an integrated circuit (IC) structure that includes: a substrate; an inductor positioned adjacent the substrate; and an electrically switchable ground shield positioned between the inductor and the substrate, wherein the electrically switchable ground shield is controlled by a transistor.

Another aspect of the disclosure provides a structure that includes an on-chip inductor; and an electrically switchable ground shield positioned between the on-chip inductor and a substrate, wherein the electrically switchable ground shield is controlled by a transistor.

A further aspect of the disclosure provides a method including: providing a structure including: a substrate; an inductor positioned adjacent the substrate; a ground shield positioned between the inductor and the substrate; and a switch connected to the ground shield and to ground; and operating the structure in any of a first mode and a second mode, wherein in the first mode the switch electrically connects the ground shield to ground and in the second mode the switch disconnects the ground shield from ground.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows an integrated circuit (IC) structure according to embodiments of the disclosure;
FIG. 2 shows an exploded isometric view of an on-chip inductor and switchable ground shield according to embodiments of the disclosure;
FIG. 3 shows a circuit model, according to embodiments of the disclosure;
FIG. 4 shows an alternative (IC) structure according to embodiments of the disclosure; and
FIG. 5 shows an exploded isometric view of an on-chip inductor and an alternative switchable ground shield according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which are shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

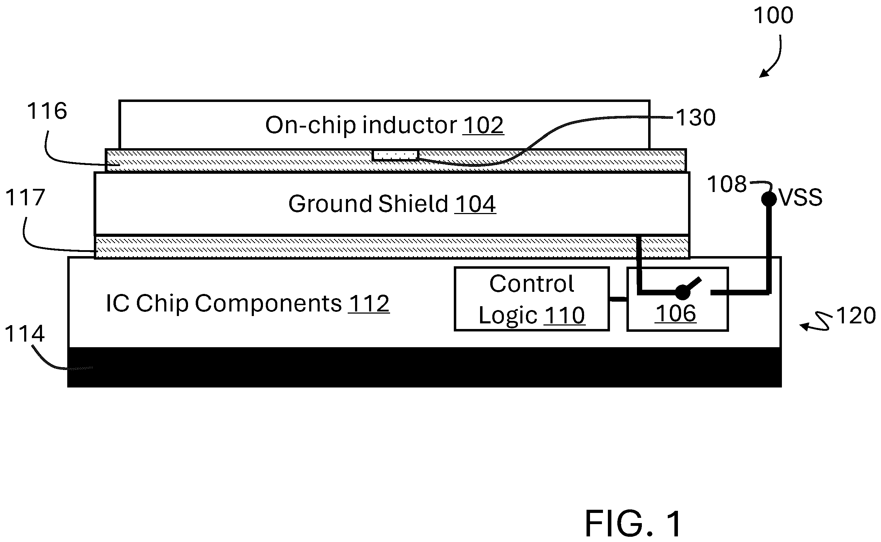

FIG. 1 depicts a cross-sectional view of an integrated circuit (IC) structure 100 that includes an on-chip inductor ("inductor") 102 that is positioned adjacent (e.g., above) substrate 120. Illustrative circuits that use on-chip inductors may for example include low noise amplifier (LNA) circuits, voltage control oscillator (VCO) circuits, power amplifier (PA) circuits, to name a few. As is readily understood in the art, the design and implementation of the on-chip inductor 102 impacts the self-resonance-frequency (SRF), which is the frequency at which the parasitic capacitance of the inductor 102 resonates with the ideal inductance of the inductor 102 resulting in an extremely high impedance, i.e., at the SRF, the inductor 102 operates like an open circuit. Accordingly, inductor 102 only operates up to its SRF. Furthermore, at the SRF where the impedance becomes very high, the inductor can attenuate signals. Thus, when choosing an inductor design for high-frequency applications, the inductor design should provide an SRF significantly higher than the operating frequency of the circuit. In lower frequency applications, a lower SRF may be preferred. As such, narrow-band circuit operations that operate at relatively lower frequencies may require a different inductor implementation than broad-band circuit operations that can operate at relatively higher frequencies. Those skilled in the art will recognize that an inductor is a passive electronic component that stores electrical energy in a magnetic field. On-chip inductors often include a metallic (e.g., copper) polygon-shaped (e.g., circular, square, octagon, etc.) spiral structure patterned with a back end of the line (BEOL) metal levels (e.g., one of the upper BEOL metal levels) of an integrated circuit (IC) chip.

IC chip structure 100 provided herein includes a switchable ground shield 104 that resides between the on-chip inductor 102 and IC chip substrate 120, which along with the control logic 110 and a metal oxide semiconductor field effect transistor (MOSFET) switch 106 allows the SRF of on-chip inductor 102 to be altered or tuned by selectively connecting to or disconnecting from a common ground 108 (VSS). In this embodiment, a first dielectric layer 116 resides between the on-chip inductor 102 and ground shield 104, and a second dielectric layer 117 resides between the substrate 120 and ground shield 104. Ground shield 104 can be a solid or patterned metallic structure in a lower back end of the line (BEOL) metal level between inductor 102 and substrate 120. Alternatively, ground shield 104 could be a solid or patterned semiconductor structure (e.g., a solid or patterned polysilicon ground shield) between inductor 102 and substrate 120. The thickness of both dielectric layers 116, 117 may vary based on the technology. As shown, a MOSFET switch 106 and control logic 110 is provided to electrically connect/disconnect ground shield 104 to/from the common ground 108. As is understood in the art, common ground 108 provides a shared reference point (e.g., zero volts) with the IC chip components 112.

Connecting/disconnecting the ground shield 104 to/from common ground 108 alters the SRF of the on-chip inductor 102, allowing the IC chip structure 100 to operate in different modes, e.g., an SRF enhanced mode and an SRF reduced mode. In the example shown, IC chip components 112 include control logic 110 configured to control the MOSFET switch 106 and thus dictate the operational mode of the on-chip inductor 102. Accordingly, using structure 100, a single IC chip can operate in different SRF modes, depending on the application running on the chip.

As noted, on-chip inductor 102 is electrically separated from the ground shield 104 by a dielectric layer 116 made from an insulator material. Accordingly, there is no direct connection between the inductor 102 and ground shield 104 / switch 106. In this illustrative embodiment, the inductor 102 and ground shield 104 are formed on top of the substrate 120. Substrate 120 is shown including IC chip components 112 and handle wafer 114, which is typically made from silicon or the like, and can be removed or etched to leave behind a functional device layer. In the case of a spiral-shaped on-chip inductor, a metal underpass connection 130 may be used to connect elements of the spiral. However, the underpass connection 130 is not electrically connected with the ground shield 104.

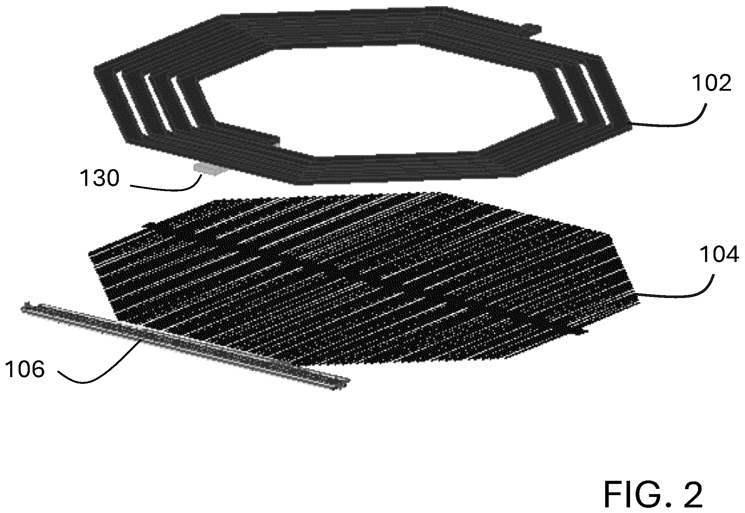

FIG. 2 depicts an exploded isometric view of an on-chip inductor 102 and switchable ground shield 104 (without the dielectric layer). In this illustrative embodiment, on-chip inductor 102 comprises a spiral configuration, however it is understood that any design / passive configuration could be implemented. Further, ground shield 104 is implemented as a Faraday mesh, which can be of any arbitrary shape capable of reducing losses due to substrate effects. The Faraday mesh for example comprises a metal mesh (e.g., copper or aluminum wire) that blocks electromagnetic fields. In this case, switch 106 may be coupled to the ground shield 104 using vias and/or other wiring below an edge of ground shield 104, and is separated from inductor 102 with dielectric layer 116. Accordingly, there is no direct connection between the switch 106 and inductor 102. In some embodiments, switch 106 is implemented as a switch stack that includes multiple switches / transistors.

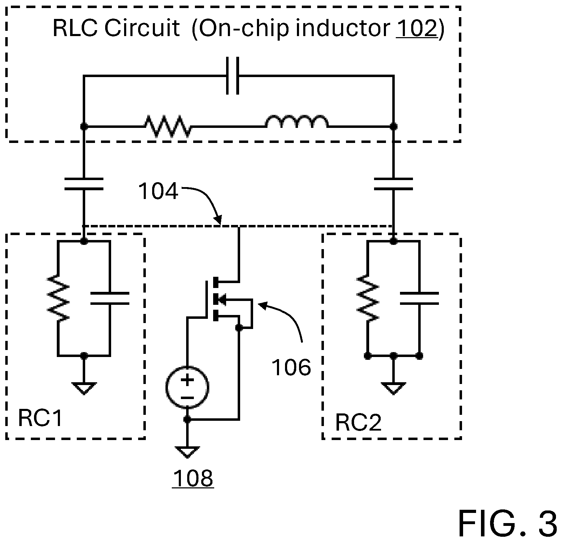

FIG. 3 depicts a circuit model of the switchable ground shield 104, in which the on-chip inductor 102 is modeled by the RLC circuit. Two RC circuits RC1 and RC2 model substrate effects. When switch 106 is on (reduced SRF mode) the ground shield 104 is electrically connected to ground and the effects of RC1 and RC2 are removed, so that a lower SRF is provided, e.g., suitable for narrow-band operations. When switch 106 is off (enhanced SRF mode) the ground shield 104 is not electrically connected to ground so that the substrate effects of RC1 and RC2 are active and provide a higher SRF, e.g., suitable for broad-band operations. The increase in SRF between the reduced and enhanced SRF modes will largely depend on the specific designs of the inductor 102 and ground shield 104. An illustrative structure can for example achieve at least a 15% increase in the SRF when switching from reduced to enhanced SRF mode.

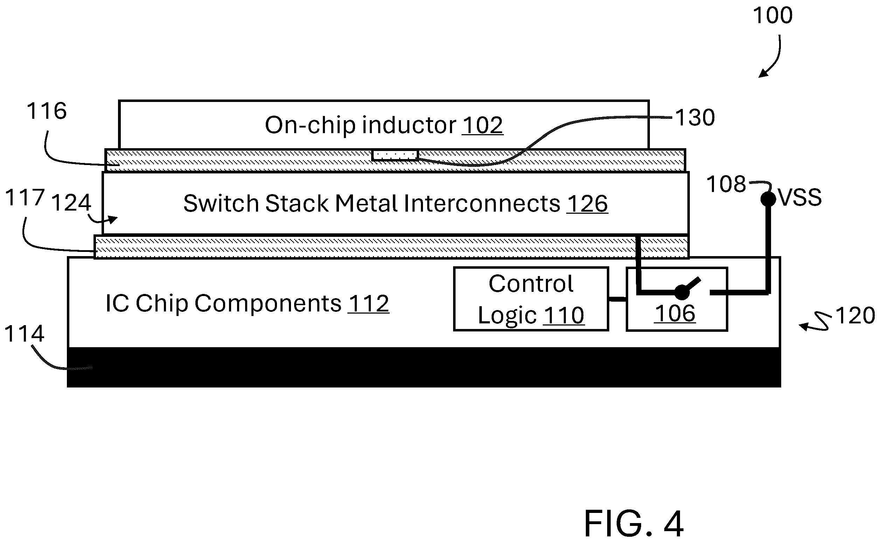

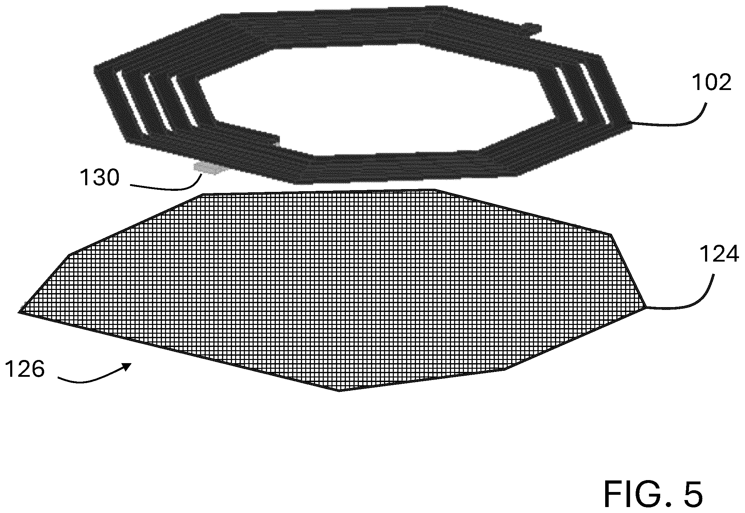

FIGS. 4 and 5 depict an alternative embodiment in which the switchable ground shield 124 is implemented with metal interconnects 126 from a switch stack having a large number of MOSFET devices. In this case, the metal interconnects 126 of the devices form a metal mesh, which provides the ground shield 124. The switch stack metal interconnects 126 may for example include a shape similar to that of the inductor 102 as shown in the exploded isometric view of FIG. 5, or may comprise any layout configured to provide shielding. In an illustrative approach, series-connected MOSFETs on the substrate 120 could be implemented in which a first MOSFET in the stack would be connected to a BEOL metal wire and a last MOSFET in the stack would be connected to ground. The MOSFETs may be "series-connected" by a combination of middle of line (MOL) contacts and BEOL vias(s) and/or wire(s) that are placed between the inductor 102 and substrate 120 and, thus, in this embodiment, the BEOL vias/wires that provide the electrical connections between series-connected MOSFETs (i.e., interconnects 126) also function as the ground shield.

For the purposes of the present embodiments, a MOSFET refers to a transistor with a semiconductor channel region positioned laterally between a source region and a drain region and with a gate (e.g., including a gate dielectric-gate conductor stack) adjacent to the channel region. However, it should be understood that the figures and discussion thereof are not intended to be limiting. For example, alternatively, a similar circuit structure could be formed using bipolar junction transistors (BJTs) and, particularly, PNP BJTs and NPN BJTs.

The terminology used herein is for the purpose of describing particular embodiments only and is not intended to be limiting of the disclosure. As used herein, reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed. It will be further understood that the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not. It will be further understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, an integrated circuit (IC) structure. The structure includes: a substrate; an inductor positioned adjacent the substrate; and an electrically switchable ground shield positioned between the inductor and the substrate, wherein the electrically switchable ground shield is controlled by a transistor.

The following embodiments are explicitly disclosed.

### Embodiment 1:

An integrated circuit (IC) structure, comprising:
an inductor; and
an electrically switchable ground shield positioned between the inductor and a substrate, wherein the electrically switchable ground shield is controlled by a transistor.

In some special illustrative examples of embodiment 1, there may be provided:
An integrated circuit (IC) structure, comprising:
a substrate;
an inductor positioned adjacent the substrate; and
an electrically switchable ground shield positioned between the inductor and the substrate, wherein the electrically switchable ground shield is controlled by a transistor.

### Embodiment 2:

The IC structure of embodiment 1, wherein the transistor provides a switch to electrically connect and disconnect the electrically switchable ground shield to/from a common ground.

### Embodiment 3:

The IC structure of embodiment 1 or 2, wherein the transistor is part of a switch stack that comprises a plurality of transistors.

### Embodiment 4:

The IC structure of embodiment 3, wherein the electrically switchable ground shield comprises metal interconnects from the switch stack.

### Embodiment 5:

The IC structure of one of embodiments 1 to 4, wherein the inductor comprises a spiral configuration.

### Embodiment 6:

The IC structure of one of embodiments 1 to 5, wherein the inductor is electrically insulated from the electrically switchable ground shield.

### Embodiment 7:

The IC structure of one of embodiments 1 to 6, wherein the electrically switchable ground shield is configured to switch between a reduced self-resonance frequency (SRF) mode and an enhanced SRF mode.

### Embodiment 8:

The IC structure of one of embodiments 1 to 7, wherein the transistor comprises a metal oxide semiconductor field effect transistor.

### Embodiment 9:

The IC structure of one of embodiments 1 to 8, wherein the substrate includes IC chip components.

### Embodiment 10:

The IC structure of embodiment 9, wherein the IC chip components include control logic for controlling the electrically switchable ground shield.

### Embodiment 11:

The structure of one of embodiments 1 to 10, wherein the inductor is an on-chip inductor.

### Embodiment 12:

A structure, comprising:
an on-chip inductor; and
an electrically switchable ground shield positioned between the on-chip inductor and a substrate, wherein the electrically switchable ground shield is controlled by a transistor.

With respect to each of embodiments 11 and 12, the term "on-chip inductor" may be understood as refering to an inductor that is directly integrated onto a semiconductor chip, often constructed as a planar spiral pattern of metal on the chip's surface, e.g., onto a substrate of the semiconductor chip.

In illustrative examples, on-chip inductors may store magnetic energy that can optimize operating characteristics of integrated circuits (ICs). On-chip inductors may be useful in high-frequency applications, such as ICs having radio frequency (RF) circuits In special illustrative examples of embodiment 11 or 12, the design and implementation of the on-chip inductor may impact the self-resonance-frequency (SRF), which may be understood as the frequency at which a parasitic capacitance of on-chip the inductor resonates with the ideal inductance of the on-chip inductor, resulting in an extremely high impedance. At the SRF, the on-chip inductor may operate like an open circuit. Accordingly, the on-chip inductor may only operate up to its SRF in the IC structure.

Furthermore, at the SRF where the impedance becomes very high, the on-chip inductor can attenuate signals. Thus, when choosing an inductor design for high-frequency applications, the inductor design may be designed so as to provide an SRF significantly higher than an operating frequency of the IC circuit in an IC structure.

In lower frequency applications, a lower SRF may be preferred. As such, narrow-band circuit operations that operate at relatively lower frequencies may require a different inductor implementation than broad-band circuit operations that can operate at relatively higher frequencies.

The on-chip inductor may be considered as a passive electronic component that stores electrical energy in a magnetic field.

In some special illustrative examples of embodiment 11 or 12, the on-chip inductor may include a metallic (e.g., copper) polygon-shaped (e.g., circular, square, octagon, etc.) spiral structure patterned with a back end of the line (BEOL) metal levels (e.g., one of the upper BEOL metal levels) of an integrated circuit (IC) chip.

In some other special illustrative examples of embodiment 11 or 12, the on-chip inductor may be electrically separated from the electrically switchable ground shield by a dielectric layer made from an insulator material. Accordingly, there may not be any direct connection between the on-chip inductor and the electrically switchable ground shield / switch. In this illustrative embodiment, the on-chip inductor and the electrically switchable ground shield may be formed on top of a substrate. The substrate may including IC chip components and/or a handle wafer (which may be made from silicon or the like and can be removed or etched to leave behind a functional device layer).

In special illustrative examples of embodiment 11 or 12 having a spiral-shaped on-chip inductor, a metal underpass connection may be used to connect elements of the spiral. In some very special instances herein, the underpass connection may not be electrically connected with the electrically switchable ground shield.

In some other special illustrative examples of embodiment 11 or 12, the on-chip inductor may be modeled by an RLC circuit including two RC circuits RC1 and RC2. For example, RC circuits RC1 and RC2 may model substrate effects.

During operation, when switch is on (reduced SRF mode), the ground shield may be electrically connected to ground and the effects of the RC circuits RC1 and RC2 may be removed, so that a lower SRF may be provided, e.g., suitable for narrow-band operations. When switch is off (enhanced SRF mode), the ground shield may not be electrically connected to ground so that the substrate effects of the RC circuits RC1 and RC2 may be active and provide a higher SRF, e.g., suitable for broad-band operations. The increase in SRF between the reduced and enhanced SRF modes may largely depend on the specific designs of the inductor and ground shield.

Some illustrative structures can, for example, achieve at least a 15% increase in the SRF when switching from reduced to enhanced SRF mode.

### Embodiment 13:

The structure of embodiment 11 or 12, wherein the transistor provides a switch to electrically connect and disconnect the electrically switchable ground shield to/from a common ground.

### Embodiment 14:

The structure of one of embodiments 11 to 13, wherein the transistor is part of a switch stack that comprises a plurality of transistors.

### Embodiment 15:

The structure of embodiment 14, wherein the electrically switchable ground shield comprises metal interconnects from the switch stack.

### Embodiment 16:

The structure of one of embodiments 11 to 15, wherein the on-chip inductor is electrically insulated from the electrically switchable ground shield.

### Embodiment 17:

The structure of one of embodiments 11 to 16, wherein the electrically switchable ground shield is configured to switch between a low self-resonance frequency (SRF) mode and a high SRF mode.

### Embodiment 18:

The structure of one of embodiments 11 to 17, wherein the substrate includes integrated circuit (IC) chip components and the IC chip components include control logic for controlling the electrically switchable ground shield.

### Embodiment 19:

A method including:
providing a structure including:
a substrate;
an inductor positioned adjacent the substrate;
a ground shield positioned between the inductor and the substrate; and
a switch connected to the ground shield and to ground; and
operating the structure in any of a first mode and a second mode, wherein in the first mode the switch electrically connects the ground shield to ground and in the second mode the switch disconnects the ground shield from ground.

### Embodiment 20:

The method of embodiment 19, wherein the switch comprises a transistor.

### Embodiment 21:

The method of embodiment 20, wherein the transistor is part of a switch stack that comprises a plurality of transistors, and wherein the ground shield is formed using metal interconnects from the switch stack.

### Embodiment 22:

The method of one of embodiments 19 to 21, wherein the structure of one of embodiments 1 to 18 is formed. That is, the structure formed in one of embodiments 19 to 21 corresponds to the structure of one of embodiments 1 to 18, structural features of embodiments 1 to 18 being formed in according method steps in the method of one of embodiments 19 to 21.

## Claims

1. An integrated circuit (IC) structure, comprising:
an inductor; and
an electrically switchable ground shield positioned between the inductor and a substrate, wherein the electrically switchable ground shield is controlled by a transistor.

2. The IC structure of claim 1, wherein the transistor provides a switch to electrically connect and disconnect the electrically switchable ground shield to/from a common ground.

3. The IC structure of claim 1 or 2, wherein the transistor is part of a switch stack that comprises a plurality of transistors.

4. The IC structure of claim 3, wherein the electrically switchable ground shield comprises metal interconnects from the switch stack.

5. The IC structure of one of claims 1 to 4, wherein the inductor comprises a spiral configuration.

6. The IC structure of one of claims 1 to 5, wherein the inductor is electrically insulated from the electrically switchable ground shield.

7. The IC structure of one of claims 1 to 6, wherein the electrically switchable ground shield is configured to switch between a reduced self-resonance frequency (SRF) mode and an enhanced SRF mode.

8. The IC structure of one of claims 1 to 7, wherein the transistor comprises a metal oxide semiconductor field effect transistor.

9. The IC structure of one of claims 1 to 8, wherein the substrate includes IC chip components, wherein the IC chip components preferably include control logic for controlling the electrically switchable ground shield.

10. The structure of one of claims 1 to 9, wherein the inductor is an on-chip inductor.

11. The structure of claim 10, wherein the on-chip inductor is electrically insulated from the electrically switchable ground shield.

12. The structure of claim 10 or 11, wherein the electrically switchable ground shield is configured to switch between a low self-resonance frequency (SRF) mode and a high SRF mode.

13. A method including:
providing a structure including:
a substrate;
an inductor positioned adjacent the substrate;
a ground shield positioned between the inductor and the substrate; and
a switch connected to the ground shield and to ground; and
operating the structure in any of a first mode and a second mode, wherein in the first mode the switch electrically connects the ground shield to ground and in the second mode the switch disconnects the ground shield from ground.

14. The method of claim 13, wherein the switch comprises a transistor.

15. The method of claim 14, wherein the transistor is part of a switch stack that comprises a plurality of transistors, and wherein the ground shield is formed using metal interconnects from the switch stack.
